Europäisches Patentamt

European Patent Office

Office européen des brevets

(11) Publication number: **0 183 518**
**A2**

## EUROPEAN PATENT APPLICATION

(21) Application number: **85308568.6**

(22) Date of filing: **26.11.85**

(51) Int. Cl.⁴: **G , 11 C 17/00**

(30) Priority: **27.11.84 GB 8429888**
**19.07.85 GB 8518330**

(43) Date of publication of application:
**04.06.86 Bulletin 86/23**

(84) Designated Contracting States:
**BE DE FR IT NL SE**

(71) Applicant: **CRYSTALATE ELECTRONICS LIMITED**
**Wharf House Medway Wharf Road**
**Tonbridge Kent TN4 1RE(GB)**

(72) Inventor: **Watson, Gerald**
**79 The Wynding**
**Bedlington Northumberland(GB)**

(72) Inventor: **Taylor, Michael**
**19 Ventnor Court Wostenholm Road**
**Sheffield(GB)**

(72) Inventor: **Dronfield, Graham Kershaw**
**7 Grassington Close**
**Hackenthorpe Sheffield(GB)**

(74) Representative: **Cole, Paul Gilbert et al,**
**Hughes Clark Byrne & Parker 63 Lincoln's Inn Fields P.O.**
**Box 22**
**London WC2A 3JU(GB)**

(54) **Programmed matrix device.**

(57) A matrix device has a permanently stored code or bit pattern comprising an electrically insulating substrate (2) having a major face carrying successively layered electrically conductive film tracks (1, 7) in non-parallel directions that traverse one another at a multiplicity of locations and are separated by a film of dielectric material (3) selected locations have pathways between the tracks of successive layers to define the code or bit pattern. At these locations the pathways are defined by programmed laser formed apertures (5) in the dielectric material (3) that access one or more film tracks (1) of a layer nearer the substrate (2). Film track material (7) of a layer further from the substrate (2) passes through the apertures (5) to make electrical contact with the accessed film tracks (1). The electrically conductive film tracks (1, 7) and the film (3) jof dielectric material are preferably thick film materials and are produced by screen printing. The conductive film tracks (1, 7) may comprise an electrically conductive material fired onto the said substrate, and the film (3) of dielectric material may comprise a glass or a glass-ceramic, also fired onto the said substrate which is a ceramic material. A method of producing the device is also claimed.

*Fig.1.*

## PROGRAMMED MATRIX DEVICE

This invention relates to a programmed matrix device of the type in which a plurality of first electrically conductive tracks supported and arranged substantially parallel with one another are traversed by one or more second electrically conductive tracks which, when in plurality, are also arranged substantially parallel with one another.

In such a device programming is achieved by arranging for one or more first tracks to be electrically connected to one or more selected second tracks at chosen regions of traversal and to be electrically insulated from the other second tracks. In one simple method of operation, electrical voltage signals are applied to all of the first tracks, and the second tracks are interrogated in turn to determine whether or not they carry a voltage. Thus by scanning the second tracks an output code (determined by the presence or absence of voltage signals on the second tracks) is obtained for the device. The code is uniquely determined by the arrangement of the connections, or otherwise, between the first and second tracks. Such a matrix device is applicable as a memory device and may be used to uniquely identify an object to which it can be attached.

It is known to provide devices of this nature which are programmed after manufacture, such programming being suitably carried out by the user. For example, electrical links may be applied to connect the desired first and second tracks, or links which have been provided during manufacture and which may be subsequently be selectively severed by some appropriate electrical or mechanical means to achieve a desired code for each particular device.

Requirements exist for matrix devices which can be programmed during manufacture such that each device is manufactured with its individual built-in code and such that no electrical connections are subsequently required to be made or broken in the device to effect programming. This means that the necessary different electrical connections between the first and second conductive tracks which are required from one individual device to the next must be readily and economically accomplished during manufacture, while the remainder of the first and second tracks are arranged, during manufacture, to be electrically insulated from one another. A problem is encountered in the provision of such programmed devices since each device has to be manufactured with its own individual code built in and from several hundred to several thousand differently programmed devices may be required.

It is an object of the present invention to overcome or minimise this problem.

The present invention provides a programmed matrix device comprising: an electrically insulating substrate; a plurality of substantially parallel first electrically conductive film tracks and one or more second electrically conductive film tracks supported on a major face of said substrate, said first and second tracks traversing one another and being separated by a film of a dielectric material except at one or more selected locations where they selectively electrically contact one another through one or more apertures in said film of dielectric material, whereby said device is programmed, said one or more apertures having been produced by means of a programmed laser.

The present invention also provides a process for the production of a programmed matrix device comprising: providing an electrically insulating substrate; providing on a major face of said substrate a plurality of substantially parallel first electrically conductive film tracks and one or more second electrically conductive film tracks, such that said first and second tracks traverse one another; providing a film of a dielectric material separating said first and second tracks; providing at one or more selected locations one or more apertures through said dielectric material by means of a programmed laser such that at said locations said first and second tracks selectively electrically contact one another through said one or more apertures, whereby said device is programmed.

The said first and second electrically conductive film tracks and the said film of dielectric material suitably comprise thick film materials and are produced by screen printing. In this respect, the said first and second tracks suitably comprise an electrically conductive material fired onto the said substrate, and the said film of dielectric material suitably comprises a glass or a glass-ceramic, likewise fired onto the said substrate.

The said substrate conveniently comprises a ceramic material, e.g. an alumina ceramic material, although other materials such as electrically insulated metals may also be used. Plastics materials may be used for the substrate when high temperature processes are not required for providing the conductive film tracks and the film of dielectric material. Electrically conductive terminations for the first and second conductive film tracks may suitably be provided along edges of the substrate.

The said laser is preferably programmed by mean of a computer.

Advantageously, for visibly identifying each device, the said laser is also used to etch or scribe onto said device a symbolic representation of a code with which said device is programmed. If desired, a strip of dielectric material may be provided on the said device, the said symbolic representation, e.g. in the form of an alphanumeric series of characters, being etched or scribed in said strip of dielectric material.

If required, electrical resistors may be provided for connection to the said first or second conductive film tracks. Such said resistors can serve as pull-up resistors to maintain a steady state electrical condition on the conductive tracks with which they are associated. The said resistors may be provided separately to said matrix device or may conveniently be provided in film or chip form on the said substrate.

In one embodiment, a single said second electrically conductive film track is provided as an input conductor for the device, the said plurality of first electrically conductive film tracks serving as output conductors for the device. Such an arrangement is applicable as a preprogrammed bit set or binary coded array, and may be embodied with or without the said resistors, the said first film tracks forming coded output lines arranged to provide binary '1' or '0' voltages. A unary input condition (i.e. a steady state '1' or '0') may be suitably arranged to be provided on the single said second film track.

This embodiment of a matrix device may advantageously be constructed as a single-in-line or dual-in-line package.

In a further embodiment a plurality of said second electrically conductive film tracks is provided, thus making provision for a plurality of input conductor lines in addition to a plurality of output conductor lines provided by the said first conductive film tracks, and thus vastly increasing the number of different codes with which the programmed devices can be made available. It is possible to provide cyclic inputs to the matrix device and if, for example sixteen input conductor lines and fifteen output conductor lines are provided, the possible range of differently coded devices available is $16^{15}$.

The said first electrically conductive film tracks may be provided on said substrate with the said one or more second electricaly conductive film tracks overlying them, or vice-versa.

If desired, one or more hybrid circuits associated with operation of the device may also be provided on the said electrically insulating substrate and electrically connected to the said first and/or second tracks.

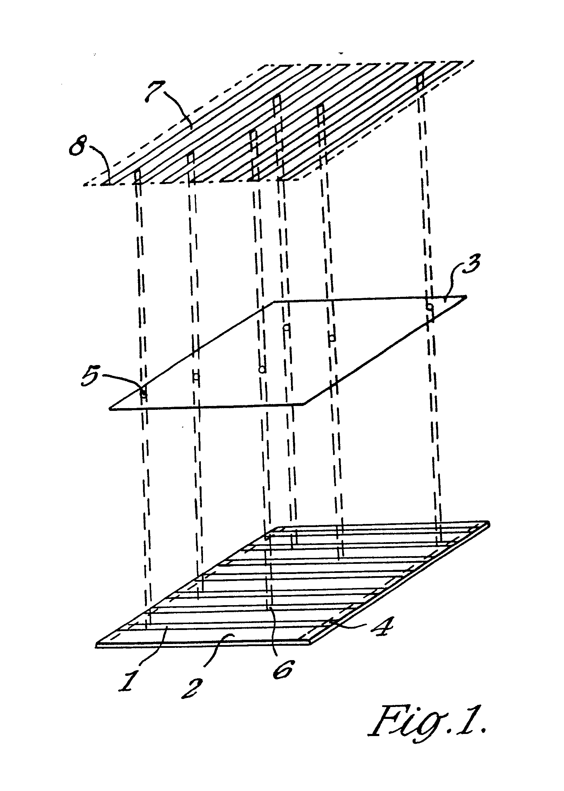

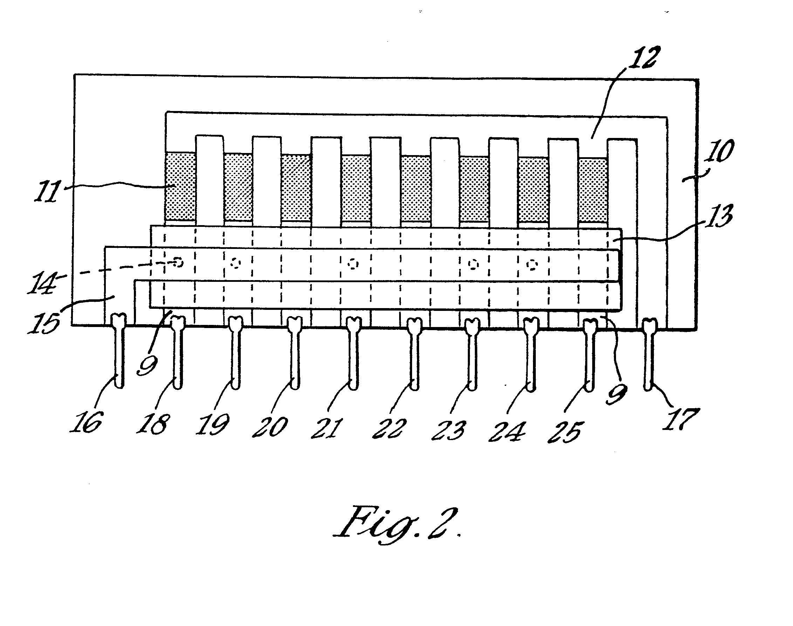

The invention is now described by way of example with reference to the accompanying drawings in which Figure 1 represents an exploded perspective view of an embodiment of a programmed matrix device according to the invention, and Figure 2 represents a plan view of another embodiment of a programmed matrix device according to the invention.

Referring to Figure 1, a plurality of first electrically conductive film tracks 1 are screen printed onto a major face of an alumina ceramic substrate 2. The tracks 1 are arranged substantially parallel with one another. An example of a suitable material for the tracks 1 is palladium-silver, (e.g. type 9308 material supplied by E.I. DuPont de Nemours and Co.), which after application by screen printing is fired at a high temperature in well-known manner. A film 3 of a dielectric material, such as DuPont type 5704 material, is screen-printed on top of the tracks 1 on the substrate 2 and fired at high temperature in known manner.

The dielectric film is applied in such a way that terminal regions 4 of the tracks 1 remain exposed at the edge of the substrate 2.

A series of apertures 5 are formed through the dielectric film 3 at selected locations, using a programmed laser, to expose portions 6 of certain of the underlying tracks 1. The number and location of the apertures 5 is important, being instrumental in enabling a predetermined programme code to be built into the matrix device during manufacture. Each device is manufactured in such a way that it has its own particular arrangement of apertures 5 provided through the dielectric film 3 and the use of a laser which is programmed, for example, by means of a computer makes this feasible. It is possible that several hundred or even several thousand different arrangements of apertures 5 may be necessary to cover a required range of uniquely programmed devices and the programmability and extremely rapid operation of a laser makes this readily achievable. A YAG laser is suitable for forming the apertures 5.

A plurality of second film conductive tracks 7 are screen printed on top of the dielectric film 3. The tracks 7 suitably comprise palladium-silver, e.g. DuPont type 9308 material, and are arranged substantially parallel with one another on the dielectric film 3 and traversing the first conductive tracks 1.

Certain of the tracks 7 are printed over the apertures 5 in the dielectric film 3 such that conductive material of these tracks 7 enters the apertures 5 and contacts the portions 6 of the underlying first tracks 1. The second conductive tracks 7 are provided with terminal regions 8.

In the resulting programmed matrix device, certain predetermined first conductive tracks 1 have therefore been electrically connected during manufacture to certain selected second conductive tracks 7. The selected interconnection, or otherwise, of the first tracks 1 and second tracks 7 is suitably such that each matrix device is programmed with a particular binary or hexadecimal code. A further advantage resulting from the use of a laser in the manufacture of the programmed matrix device of the invention is that a representation of the code programmed into each particular device can also be written by the laser onto some convenient part of the device using appropriate symbols, e.g. an alphanumeric series of characters, to allow each device to be readily and visibly identified. For this purpose a strip of dielectric material of the type used for the film 3 could conveniently be applied to the device and the particular code etched onto it by means of the laser.

In one simple method of operation, electrical voltage signals are applied to the terminal regions 4 of all of the first tracks 1 and the second tracks 7 are interrogated in turn at their terminal regions 8 to determine whether or not they carry a voltage signal. Thus by scanning the second tracks 7 an output code (determined by the presence or absence of voltage signals on the individual second tracks 7 ) is obtained.

This code is uniquely determined for each programmed device by the arrangement of connections between the first tracks 1 and second tracks 7 through the apertures 5 in the dielectric 3.

If desired, the substrate 2 may be made sufficiently large to enable one or more hybrid circuits (not shown), associated with operation of the device, to be provided thereon and electrically connected to the said first and second tracks.

Although in the process described above the apertures 5 are formed in the screen-printed dielectric film 3 after firing the dielectric film 3, if desired the apertures 5 may be formed by the laser in the unfired dielectric film 3 followed by screen-printing of the second conductive film tracks 7. The dielectric film 3 and second tracks 7 are then co-fired at the appropriate high temperature.

Referring now to Figure 2, this illustrates an example of another embodiment of a programmed matrix device according to the invention but which involves substantially the same materials and technology as described with reference to Figure 1. A plurality of first substantially parallel electrically conductive film tracks 9 are applied by screen printing and firing onto a major face of an alumina ceramic substrate 10. A plurality of elongate film resistance elements 11 are deposited by well known screen printing and firing techniques onto the substrate 10 so that one end of each of the resistance elements 11 is in electrical contact with an associated conductive film track 9. The other end of each resistance element 11 is arranged to make electrical contact with a common film conductor 12 which is screen printed onto the substrate 10. A film 13 of a dielectric material is screen printed onto the substrate 10 and over portions of the first conductive film tracks 9 and fired in a well known manner. A series of apertures 14 are formed through the dielectric film 13 at selected locations, using a programmed laser, to expose portions of certain of the underlying tracks 9. As in the embodiment of Figure 1, the number and locations of the apertures 14 is important, being instrumental in enabling a predetermined programme code to be built into the device during manufacture. Each device is manufactured so that it has its own particular arrangement of apertures 14 provided through the dielectric film 13 and the use of a programmed laser makes this feasible.

A single second film conductive track 15 is screen printed on top of the dielectric film 13 and over the apertures 14 so that conductive material of the track 15 enters the apertures 14 and contacts the underlying first tracks 9. A row of terminals 16 to 25 is provided extending from one edge of the substrate 10 and such that termainal 16 makes electrical contact with the single second conductive track 15, terminal 17 makes contact with conductor 12 and terminals 18 to 25 make contact with respective first film conductive tracks 9.

An electrically insulating protective covering (not shown) may be provided over the device, apart from the terminals 16 to 25, the resulting arrangement appropriately taking the well known form of a single-in-line package (S.I.P.). If required, two such devices could be provided, appropriately interconnected and presented in the well known form of a dual-in-line package (D.I.P.).

The device shown in Figure 2 functions as an eight-bit set with the resistance elements 11 operating as pull-up resistors. When a unary input condition (i.e. a steady style '1' or '0') is provided on the single second film conductive track 15 by connecting a suitable source to terminals 16 and 17, a binary coded output is obtained at the terminals 18 to 25. The output code is permanently and uniquely determined for a particular device during manufacture according to the locations of the apertures 14 produced by the programmed laser. In the case of the eight-bit device shown in Figure 2, a range of such devices identified by numbers between 0 and 255 can be provided. If sixteen-bit devices are produced, these will cover the number range 0 to to 65,535. Twenty-four-bit devices will cover the number range 0 to 16,777,215 and thirty-two-bit devices will cover the number range 0 to 4,294 millions.

The pull-up resistors 11 maintain a steady state electrical condition on the conductive tracks with which they are associated and prevent short-circuiting of the supply connected to terminals 16 and 17.

Devices may also be produced as shown in Figure 2 but without the resistors 11. The embodiment of Figure 1 may also be provided with resistors connected to the first or second conductive tracks 1 or 7.

Numerous applications are envisaged for the device of the invention, relating for example to identification of animals, objects on production lines, luggage at airports, electronic locks and identifying tags for personal use or for attachment to moving vehicles of all types.

CLAIMS:

1.    A matrix device having a permanently stored code or bit pattern comprising an electrically insulating substrate (2) having a major face carrying successively layered electrically conductive film tracks (1, 7) in non-parallel directions that traverse one another at a multiplicity of locations and are separated by a film of dielectric material (3), selected locations having pathways between the tracks of successive layers to define the code or bit pattern, characterised in that programmed laser formed apertures (5) in the dielectric material (3) at the selected locations access one or more film tracks (1) of a layer nearer the substrate (2), and film track material (7) of a layer further from the substrate (2) passes through the apertures (5) to make electrical contact with the accessed film tracks (1).

2.    A device according to claim 1 in which the said electrically conductive film tracks (1, 7) and the said film (3) of dielectric material comprise thick film materials, are produced by screen printing, the conductive film tracks (1, 7) comprising an electrically conductive material fired onto the said substrate, and the said film (3) of dielectric material comprising a glass or a glass-ceramic, also fired onto the said substrate, and wherein said substrate is a ceramic material.

3.    A device according to Claim 1 or 2, in which electrically conductive terminations (4, 8) for the conductive film tracks (1, 7) are provided along edges of the substrate (1).

4.    A device according to any preceding Claim in which the said laser is also used to etch or scribe onto said device a symbolic representation of a code with which said device is programmed, optionally by providing a strip of dielectric material on the said device and etching or scribing the said symbolic representation in said strip of dielectric material and optionally in the form of an alphanumeric series of characters.

5.    A device according to any preceding claim in which one or more electrical resistors (11) are provided for connection to one or more of said conductive film tracks (9), said resistors (11) being adapted to serve as pull-up resistors arranged to maintain a steady state electrical condition on the conductive tracks (9) with which they are associated, said resistors (11) being provided in film or chip form on said substrate (10).

6.    A device according to any preceding claim in which a single electrically conductive film track (15) along one direction is provided as an input conductor for the device, a plurality of electrically conductive film tracks (9) which traverse said single track (15) and are separated therefrom by said dielectric film (3) serving as output conductors for the device.

7.    A device according to Claim 6 constructed as a single-in-line or dual-in-line package.

8.    A device according to any preceding claim, in which one or more hybrid circuits is or are provided on the said electrically insulating substrate and electrically connected to the said conductive tracks.

9.    A process for the production of a programmed matrix device comprising: providing an electrically insulating substrate (2) having a major face carrying a first layer comprising at least one electrically conductive film track (1) and a second layer which is a film (3) of dielectric material overlying the or each track (1), forming apertures (5) in the dielectric material at selected locations by means of a programmed laser to access the one or more film tracks (1) at the selected locations, and forming a third layer of at least one electrically conductive film track (7) in a direction non-parallel to the or each first track (1) with the tracks (1, 7) traversing one another at a multiplicity of locations including the selected locations and so that film track material (7) of the third layer passes through the apertures (5) to make electrical contact with the accessed film tracks (1) of the first layer to connect the tracks (1, 7) of the first and third layers and define a selected code or bit pattern.

10.    A process according to Claim 9 including the steps of screen printing at least one electrically conductive film track in a first direction onto a glass or glass-ceramic substrate, over-printing the or each film track with dielectric material, printing film tracks in a second direction onto the substrate and firing the printed substrate.

*Fig.1.*

Fig. 2.